# EUROPEAN PATENT APPLICATION

(11) **EP 3 229 565 A1**
(43) Date of publication of application: **11.10.2017**
(21) Application number: 17165397.5
(22) Date of filing: 07.04.2017
(51) Int. Cl.: H05K 3/28, H05K 1/02

(54) **SUBSTRATE UNIT AND METHOD OF MANUFACTURING SUBSTRATE UNIT**

(30) Priority: 07.04.2016 JP 2016077147
(71) Applicant: Azbil Corporation, Chiyoda-ku Tokyo 100-6419 (JP)
(72) Inventor: NAGOYA, Hiroaki, Tokyo, Tokyo 100-6419 (JP)
(74) Representative: Lavoix

(57) **Abstract**

To improve a substrate unit in which safety maintaining devices are mounted on a wiring substrate while suppressing manufacturing costs.

A substrate unit includes a wiring substrate, electronic components as safety maintaining devices arranged on the wiring substrate, plural metal components arranged on the wiring substrate at distances from the electronic components as the safety maintaining devices so as to satisfy a requirement for an intrinsically safe explosion-proof construction, and a resin film covering at least one of the plural metal components and the electronic components as the safety maintaining devices on the wiring substrate, in which the resin film has a thermal conductivity of at least 1.0W/mk and a dielectric breakdown strength of at least 3.0kV/mm.

## Description

### TECHNICAL FIELD

The present invention relates to a substrate unit in which electronic components are mounted on a wiring substrate, and for example, relates to a substrate unit to be loaded on a positioner which requires an intrinsically safe explosion-proof construction and a method of manufacturing the substrate unit.

### BACKGROUND

The intrinsically safe explosion-proof construction is necessary for industrial products, such as a positioner and a pressure transmitter for controlling a regulating valve used in a flow process control in a chemical plant and the like, because these products may be used in an environment with an explosive atmosphere in which combustible gas is filled.

As a requirement for approving industrial products as those having the intrinsically safe explosion-proof construction, it is necessary to design electronic components that limit electric energy used inside the industrial products, such as a Zener diode,
as safety maintaining devices operating with the total amount of electric energy being suppressed to a predetermined value or less (Standard IEC60079-11).

The safety maintaining devices are required to operate within a rated range even when 1.5 times the maximum power that can be applied on circuit design is applied.

In the case of the Zener diode, additional heat dissipation measures may be necessary when temperature increase exceeding the rated range occurs in a power application test performed for evaluating intrinsically safe explosion-proof performance after the diode is actually mounted on the wiring substrate (printed board).

As common heat dissipation measures, a method of increasing an area of wiring patterns (copper foil patterns) as wirings around an electronic component (Zener diode) as a heat dissipation target on the printed board, a method of packing a great deal of potting material having a high thermal conductivity inside a heat sink where the printed board is housed (refer to JP 2006-24746 A), and so on are known.

### SUMMARY

However, the above heat dissipation measures in related art are not appropriate methods for increasing heat dissipation properties of the substrate unit on which safety maintaining devices are mounted as described below.

In intrinsically safe explosion-proof products, it is necessary, for example, to increase insulating properties between the safety maintaining device itself and peripheral conductors, to increase insulating properties between peripheral conductors around the safety maintaining device, and so on for allowing the safety maintaining device to surely function. Specifically, it is necessary to arrange regions where high insulating properties are necessary in the safety maintaining device and peripheral conductors so as to be separated from the peripheral conductors by given distances. Accordingly, in the method of increasing the area of wiring patterns around the safety maintaining device, it is necessary to increase the area of wiring patterns for heat dissipation as compared with common industrial products not requiring the intrinsically safe explosion-proof construction, which incurs the increase in size of the printed board. As this is contrary to the increasing requirement of size reduction in products in recent years, it is not realistic.

In the method of packing a great deal of potting material having high thermal conductivity inside a heat sink disclosed in JP 2006-24746 A, the heat sink is separately required as well as a great deal of potting material is necessary, which incurs the increase in costs of components.

Furthermore, heat dissipation measures of the substrate unit requiring the intrinsically safe explosion-proof construction become necessary in many cases after performing the evaluation test for the intrinsically safe explosion-proof performance as described above. Therefore, re-construction and re-evaluation of the substrate unit are necessary due to re-design of the printed board, and the addition of the heat sink and so on in all of the above related-art methods incurs the increase of man-hours.

As the heat dissipation measures in related art incurs the increase of man-hours or the increase of manufacturing costs, such as component costs as described above, they are not appropriate methods for increasing heat dissipation properties of the substrate unit in which the safety maintaining device is mounted on the printed board.

The present invention has been made in view of the above problems, and an object of the present invention is to improve heat dissipation properties of the substrate unit in which the safety maintaining device is mounted on the wiring substrate while suppressing manufacturing costs.

A substrate unit (100, 100A) according to the present invention includes a wiring substrate (1), electronic components (2_1, 2_2) as safety maintaining devices arranged on the wiring substrate, plural metal components (3C to 3F, 4) arranged on the wiring substrate at distances from the electronic components (2_1, 2_2) as the safety maintaining devices so as to satisfy a requirement for an intrinsically safe explosion-proof construction, and a resin film (7) covering at least one of the plural metal components (3C to 3F, 4) and the electronic components (2_1, 2_2) as the safety maintaining devices on the wiring substrate, in which the resin film (7) has a thermal conductivity of at least 1.0W/mk and a dielectric breakdown strength of at least 3.0kV/mm.

In the substrate unit, the metal components covered by the resin film may include wirings (3C to 3F) formed on the wiring substrate.

In the substrate unit, the wiring (3C) does not have to be connected to another electronic component different from the electronic components as the safety maintaining devices.

In the substrate unit, the wirings may have holes (30a to 30c) formed in a direction perpendicular to a surface (1X) of the wiring substrate.

In the substrate unit, the metal components covered by the resin film may include fixing components (4) made of metal for fixing the wiring substrate to a casing.

In the substrate unit, a viscosity of the resin before curing may be at least 50 Pa·s.

In the substrate unit, the electronic components as the safety maintaining devices may be Zener diodes (2_1, 2_2).

In the above explanation, reference numerals and signs on the drawings corresponding to components of the invention are written as examples with brackets.

As described above, it is possible to improve heat dissipation properties of the substrate unit in which safety maintaining components are mounted on the wiring substrate while suppressing manufacturing costs according to the embodiment of the invention.

### BRIEF DESCRIPTION OF THE DRAWINGS

Fig. 1 is a plan view schematically showing a structure of a substrate unit according to an embodiment of the present invention.
Fig. 2 is a plan view schematically showing heat dissipation paths of the substrate unit according to an embodiment of the present invention.
Fig. 3 is a plan view schematically showing another structure of the substrate unit according to an embodiment of the present invention.
Fig. 4 is a flow chart showing a method of manufacturing the substrate unit according to an embodiment of the present invention.
Fig. 5 is a plan view schematically showing a structure of a substrate unit before a resin film is formed.

### DETAILED DESCRIPTION

Hereinafter, an embodiment of the present invention will be explained with reference to the drawings.

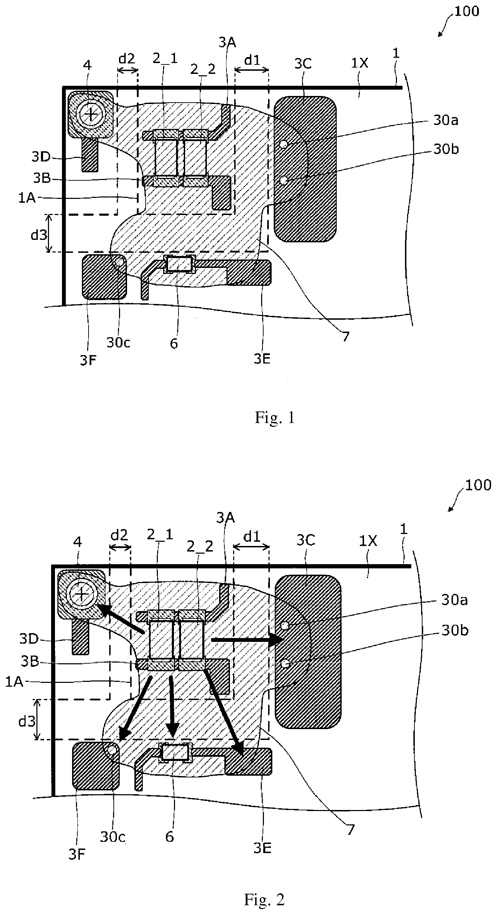

Fig. 1 is a plan view schematically showing a structure of a substrate unit according to an embodiment of the present invention.

A substrate unit 100 shown in Fig. 1 is one electronic circuit module in which an electronic circuit constituting part of an industrial product requiring an intrinsically safe explosion-proof construction is formed on a wiring substrate. The substrate unit 100 includes a wiring substrate 1, electronic components and metal components mounted on the wiring substrate 1 and a resin film 7.

The wiring substrate 1 is, for example, a printed board, in which wiring patterns as metal wirings made of a metal material (for example, a metal material containing copper) are formed on the substrate surface (back surface) and inside the substrate. In Fig. 1, wiring patterns 3A to 3F are shown as examples of the metal wirings. Moreover, fixing components (for example, screws and nuts) 4 made of metal for fixing the wiring substrate 1 are mounted on the wiring substrate 1, for example, in a casing (a not-shown metal case) for housing the substrate unit 100.

The above electronic components are mounted by being soldered appropriately to the wiring formed on the wiring substrate 1. As the electronic components, a microcomputer, a transistor, a Zener diode, a capacitor, a resistor, a coil and so on can be cited as examples. In Fig. 1, a case where two Zener diodes 2_1 and 2_2, which are connected in parallel, and a resistor 6 are mounted as the electronic components on the surface 1X of the wiring substrate 1 is shown.

Here, the Zener diodes 2_1 and 2_2 are designed as safety maintaining devices. In order to allow these devices to surely function, an area 1A where the Zener diodes 2_1 and 2_2 are arranged and peripheral conductors thereof are arranged apart from one another by distances satisfying a requirement for the intrinsically safe explosion-proof construction. For example, the area 1A where the Zener diodes 2_1 and 2_2 as the safety maintaining devices are arranged and other wiring patterns 3C to 3E are arranged apart from one another by predetermined distances d1 to d3 as shown in Fig. 1.

The resin film 7 forms heat dissipation paths for the safety maintaining devices. The resin film 7 is formed by continuously applying a potting material made of resin to necessary places on the wiring substrate 1 after necessary wiring patterns are formed and the electronic components are mounted on the wiring substrate 1.

It is desirable that the resin film 7 has as high thermal conductivity and dielectric breakdown strength as possible. Specifically, the potting material made of the cured resin, that is, the resin film 7 desirably has at least a thermal conductivity of 1.0W/mK.

In explosion proof standards, withstanding voltage characteristics of 1500Vrms is required at the minimum between an intrinsically safe circuit and a non-intrinsically safe circuit. Therefore, the resin film 7 desirably has a dielectric breakdown strength of, for example, at least 3.0kV/mm in consideration of the distance therebetween.

As the resin, a silicon resin, an epoxy resin, a urethane resin, and the like can be cited as examples. It is desirable that a viscosity of the resin before curing is at least 50Pa·s.

As the resin (potting material) for forming the resin film 7, for example, a thermal conductive silicone adhesive (SE 4487 manufactured by Dow Corning Toray Co., Ltd.) having a thermal conductivity of 2.8W/mK, a dielectric breakdown strength of 19kV/mm, and a viscosity before curing of 230Pa·s can be used.

The potting material is continuously applied from the Zener diodes 2_1 and 2_2 as the safety maintaining devices to at least one metal component existing on the wiring substrate 1 and cured, thereby forming the resin film 7, so as to cover the Zener diodes 2_1 and 2_2 and the at least one metal component. For example, when the potting material is applied so as to cover the Zener diodes 2_1 and 2_2, the wiring patterns 3C and 3F to which an electronic component is not connected, the wiring patterns 3E to which the resistor 6 is connected and the fixing components 4, the resin film 7 can be formed so as to entirely cover the Zener diodes 2_1 and 2_2 and peripheral metal components as shown in Fig. 1.

The heat dissipation paths from the Zener diodes 2_1 and 2_2 to the wiring pattern 3B, the wiring pattern 3E and the fixing components 4 can be formed by forming the resin film 7 as shown in Fig. 2. Accordingly, heat generated in the Zener diodes 2_1 and 2_2 can be dissipated to the wiring pattern 3C, the wiring pattern 3E, and the fixing components 4 while maintaining insulating properties between the Zener diodes 2_1, 2_2 and the wiring pattern 3C, the wiring pattern 3E, and the fixing components 4, thereby increasing heat dissipation properties of the substrate unit 100.

Moreover, the resin film 7 is formed so as to cover holes 30a to 30c such as through holes and via holes formed in the wiring patterns 3C and 3F in a direction perpendicular to the surface 1X of the wiring substrate 1 as shown in Fig. 1, thereby dissipating heat not only to the surface of the wiring substrate 1 but also to wiring patterns and the like formed on the back surface and an intermediate layer of the wiring substrate 1. As a result, further improvement of the heat dissipation properties can be expected.

The resin film 7 is preferably formed so as to directly contact metal components such as copper foil patterns (wiring patterns) as heat dissipation destinations, however, in the case where a resist film is formed on a surface layer of the copper foil pattern, the resin film 7 may be formed on the resistor film. Generally, a film thickness of the resist film is sufficiently small, heat dissipation effect of a certain degree or more can be expected even when the resin film 7 is formed on the resist film of the copper pattern.

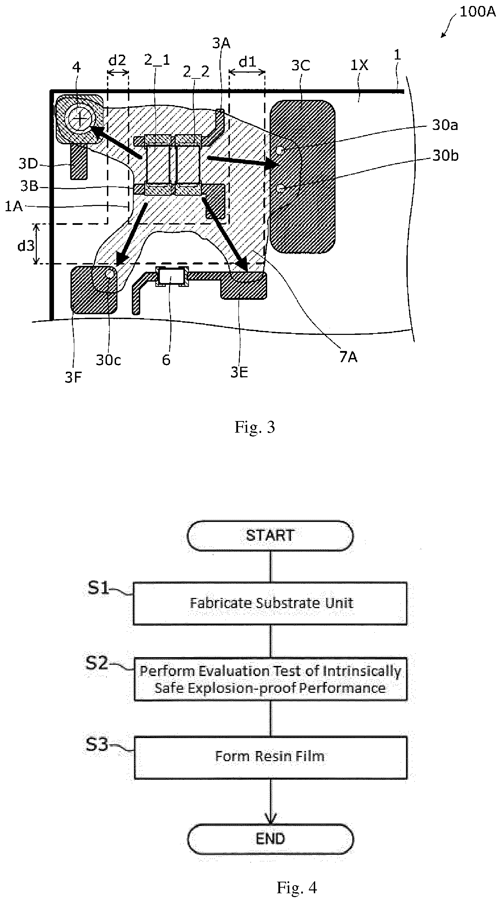

A position on the wiring substrate 1 where the resist film 7 is formed is not limited to the example shown in Fig. 1, and the potting material may be continuously applied to positions where the heat dissipation paths of the Zener diodes 2_1 and 2_2 as the safety maintaining devices are desired to be formed. For example, in order to avoid propagation of heat to electronic components other than the safety maintaining devices as heat dissipation targets, it may be preferable to form the resin film 7 to entirely cover the safety maintaining devices as heat dissipation targets and only metal components to which other electronic components are not connected. For example, in order to avoid propagation of heat generated in the Zener diodes 2_1 and 2_2 to the resistor 6, it may be preferable that the potting material is continuously applied from the Zener diodes 2_1 and 2_2 to the wiring pattern 3C and the fixing components 4 except the resistor 6, thereby forming a resin film 7A that covers the Zener diodes 2_1 and 2_2, the wiring pattern 3C, and the fixing components 4, as in a substrate unit 100A shown in Fig. 3. Accordingly, heat dissipation properties can be increased while reducing adverse effects to electronic components with low heat resistance, electronic components sensitive to temperature changes, and so on.

Next, a method of manufacturing the substrate unit 100 satisfying requirements for intrinsically safe explosion-proof construction will be explained.

Fig. 4 is a flow chart showing the method of manufacturing the substrate unit 100 according to an embodiment of the present invention.

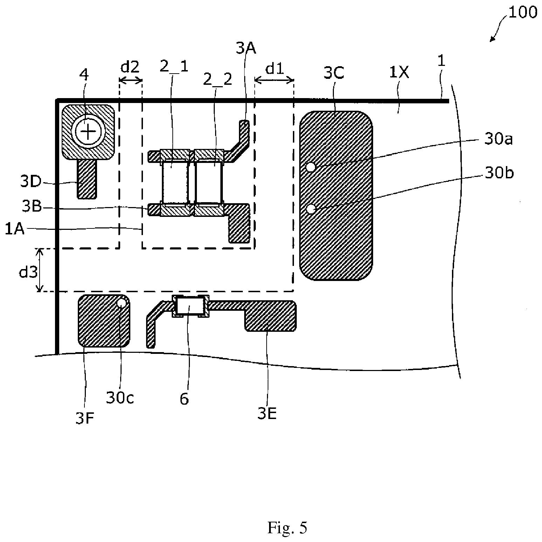

As shown in Fig. 4, first, necessary metal wirings (wiring patterns 3A to 3F) are formed on the wiring substrate 1 by patterning, and electronic components (Zener diodes 2_1 and 2_2) as the safety maintaining devices are mounted on the wiring substrate 1 so as to satisfy the requirements for intrinsically safe explosion-proof construction, thereby fabricating the substrate unit 100 (S1)--for example, as illustrated in Fig. 5.

Next, an evaluation test for the intrinsically safe explosion-proof performance including the above power application test is performed for determining whether the substrate unit 100 fabricated in Step 1 actually satisfies the requirements for intrinsically safe explosion-proof construction or not (S2).

Next, when temperature increase exceeding the rated range occurs from the Zener diodes 2_1 and 2_2 in the evaluation test (for example, the power application test) performed in Step S2, the potting material is continuously applied from the Zener diodes 2_1 and 2_2 to at least one of metal component on the wiring substrate 1 to form the resin film 7 (S3). After that, the process returns to Step S2 to execute the evaluation test according to need, and the resin film 7 is additionally formed at places where heat dissipation is necessary until it is confirmed that the heat dissipation performance of the substrate unit 100 is improved and no problem occurs.

When the substrate unit according to the present invention is adopted as described above, the resin film is formed at places where heat dissipation is necessary after the evaluation test of the intrinsically safe explosion-proof performance is performed to thereby improve the heat dissipation properties. Therefore, re-design of the wiring substrate and addition of components, such as a heat sink, performed in related-art heat dissipation measures are not necessary. Furthermore, a great deal of resin, the casing for the resin, and so on used in the related-art method in which the resin is packed in the heat sink are not necessary. That is, it is possible to suppress man-hours or manufacturing costs, such as component costs, by adopting the substrate unit according to the present invention.

Furthermore, the resin film having a high heat conductivity and a high dielectric breakdown strength is formed on the wiring substrate, thereby forming heat dissipation paths of the safety maintaining devices while maintaining insulating properties between the safety maintaining devices and other metal components arranged on the wiring substrate.

Accordingly, it is possible to improve heat dissipation properties of the substrate unit in which safety maintaining devices are mounted on the wiring substrate while suppressing manufacturing costs by adopting the substrate unit according to the present invention.

Moreover, it is possible to prevent the resin before curing from flowing on the wiring substrate and to prevent formation of the resin film at an undesired place by forming the resin film by using the resin with high viscosity. Therefore, the resin film with a desired shape can be easily formed at a desired place on the wiring substrate.

In order to satisfy the requirements for intrinsically safe explosion-proof construction, coating by varnish and the like is necessary for preventing a short circuit fault between conductors. A function of coating can be also obtained by forming the above resin film on the wiring substrate. Therefore, varnish processing in an area where the resin film is formed can be omitted.

The invention made by present inventors has been specifically described based on the embodiment as the above, the present invention is not limited to this, and it goes without saying that various alterations may be made within a scope not departing from the gist of the invention.

For example, the Zener diodes 2_1 and 2_2 are shown as examples of the electronic components as heat dissipation targets in the above embodiment. However, the present invention is not limited to this, and other electronic components, such as resistors and diodes, may be targets.

Although the fixing components 4, the wiring pattern 3C, and the like are shown as metal components covered by the resin film 7, the present invention is not limited to this, and other metal components existing on the wiring substrate 1 may be covered. For example, a solid ground pattern formed on the wiring substrate 1 may be covered. It is also preferable that the resin film 7 is formed so as to extend from the electronic component as the heat dissipation target to the metal case for housing the substrate unit 100 via the wiring substrate 1.

### DESCRIPTION OF REFERENCE NUMERALS AND SIGNS

100, 100A: substrate unit
1: wiring substrate
2_1, 2_2: Zener diode
3A to 3F: wiring pattern
4: fixing component
6: resistor
7, 7A: resin film
30a to 30c: hole

## Claims

1. A substrate unit (100, 100A) comprising:
a wiring substrate (1);
one or more electronic components (2_1, 2_2) as safety maintaining devices arranged on the wiring substrate (1);
plural metal components arranged on the wiring substrate (1) at distances from the one or more electronic components (2_1, 2_2) so as to satisfy a requirement for an intrinsically safe explosion-proof construction; and
a resin film (7, 7A) covering at least one of the plural metal components and the one or more electronic components (2_1, 2_2) as the safety maintaining devices on the wiring substrate (1),
wherein the resin film (7, 7A) has a thermal conductivity of at least 1.0W/mk and a dielectric breakdown strength of at least 3.0kV/mm.

2. The substrate unit (100, 100A) according to claim 1,
wherein the at least one metal component covered by the resin film (7, 7A) include one or more wirings formed on the wiring substrate (1).

3. The substrate unit (100, 100A) according to claim 2,
wherein the wirings are not connected to another electronic component different from the one or more electronic components (2_1, 2_2) as the safety maintaining devices.

4. The substrate unit (100, 100A) according to claim 2 or 3,
wherein the wirings have holes formed in a direction perpendicular to a surface of the wiring substrate (1).

5. The substrate unit (100, 100A) according to any one of claims 1 to 4,
wherein the at least one metal component covered by the resin film (7, 7A) includes one or more fixing components (4) made of metal for fixing the wiring substrate (1) to a casing.

6. The substrate unit (100, 100A) according to any one of claims 1 to 5,
wherein a viscosity of the resin before curing is at least 50Pa·s.

7. The substrate unit (100, 100A) according to any one of claims 1 to 6,
wherein the one or more electronic components (2_1, 2_2) as the safety maintaining devices are Zener diodes.

8. A method of manufacturing a substrate unit (100, 100A) comprising:
fabricating the substrate unit (100, 100A) by mounting one or more electronic components (2_1, 2_2) as safety maintaining devices and plural metal components on a wiring substrate (1) at distances from one another so as to satisfy a requirement for an intrinsically safe explosion-proof construction;
performing an evaluation test for intrinsically safe explosion-proof performance with respect to the substrate unit (100, 100A); and
integrally forming a resin film (7, 7A) covering at least one of the plural metal components and the one or more electronic components (2_1, 2_2) as the safety maintaining devices by applying a resin having a thermal conductivity of at least 1.0W/mk and a dielectric breakdown strength of at least 3.0kV/mm after curing on the wiring substrate (1).

9. The method of manufacturing the substrate unit (100, 100A) according to claim 8,
wherein the at least one metal component covered by the resin film (7, 7A) includes one or more wirings formed on the wiring substrate (1).

10. The method of manufacturing the substrate unit (100, 100A) according to claim 8 or 9,
wherein the at least one metal component covered by the resin film (7, 7A) includes one or more fixing components (4) made of metal for fixing the wiring substrate (1) to a casing.
